(19) **Europäisches Patentamt · European Patent Office · Office européen des brevets**

(11) **EP 2 586 057 B1**

(12) **FASCICULE DE BREVET EUROPEEN**

(45) Date de publication et mention de la délivrance du brevet:
**04.05.2016 Bulletin 2016/18**

(21) Numéro de dépôt: **11728242.6**

(22) Date de dépôt: **22.06.2011**

(51) Int Cl.:
*H01L 23/427* (2006.01)  *H01L 35/30* (2006.01)

(86) Numéro de dépôt international:
**PCT/EP2011/060456**

(87) Numéro de publication internationale:
**WO 2011/161167 (29.12.2011 Gazette 2011/52)**

(54) **THERMOGENERATEUR A MATERIAUX A CHANGEMENT DE PHASE**

THERMOGENERATOR MIT PHASENÄNDERUNSMATERIALEN

THERMOGENERATOR COMPRISING PHASE-CHANGE MATERIALS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.06.2010 FR 1055005**

(43) Date de publication de la demande:
**01.05.2013 Bulletin 2013/18**

(73) Titulaire: **Commissariat à l'Énergie Atomique et aux Énergies Alternatives 75015 Paris (FR)**

(72) Inventeur: **GAVILLET, Jérôme F-38120 Saint-Egrève (FR)**

(74) Mandataire: **Ilgart, Jean-Christophe et al BREVALEX 95, rue d'Amsterdam 75378 Paris Cedex 8 (FR)**

(56) Documents cités:
**US-A1- 2003 062 150    US-A1- 2003 143 958
US-A1- 2004 238 022    US-A1- 2008 168 775**

## Description

### DOMAINE TECHNIQUE ET ART ANTÉRIEUR

La présente invention se rapporte à un thermogénérateur utilisant des matériaux à changement de phase, et plus généralement à une source d'énergie thermoélectrique.

On désigne par effet thermoélectrique, l'apparition d'une différence de potentiel à la jonction de deux matériaux conducteurs de natures différentes soumise à une différence de température, cet effet est également appelé effet Seebeck.

L'utilisation la plus connue de l'effet Seebeck est la mesure de température à l'aide de thermocouples.

Jusqu'à présent, les systèmes de conversion thermoélectriques ou sources thermoélectriques pour produire de l'électricité à partir de la chaleur ont été cantonnés aux marchés de niche du fait de leurs faibles rendements et de leurs coûts élevés.

Dans le cas d'un environnement dans lequel la température est la plus souvent strictement homogène, le système n'est pas soumis à un gradient de température de manière continue. Il faut alors prévoir une batterie électrique pour stocker le courant généré, lorsqu'un gradient de température apparaît. Par conséquent, la production d'électricité est soumise à des événements qui ne sont pas-maîtrisés.

Par ailleurs, dans le cas de systèmes autonomes, i.e. non reliés à un dispositif de contrôle de la différence de température, la différence de température est fluctuante et ne permet pas la génération constante de tension et de courant. Ceci est particulièrement gênant dans le cas d'une alimentation d'une batterie, qui supporte mal la variation de tension à ses bornes.

Le document EP 1 001 470 décrit une montre à bracelet alimentée par un élément thermoélectrique. Deux éléments à matériaux à changement de phase peuvent être prévus. Dans la disposition prévue et dans le fonctionnement prévu, il n'est pas possible de maîtriser le gradient thermique au sein de l'élément thermoélectrique de sorte qu'il soit constant sur une période donnée et que l'élément thermoélectrique délivre une puissance électrique stable.

US 2003/143958 divulgue un dispositif dans lequel un générateur thermoélectrique est disposé entre un composant électronique et un matériau à changement de phase.

C'est par conséquent un but de la présente invention d'offrir un thermogénérateur mettant en oeuvre des matériaux à changement de phase, pour lequel la génération d'une puissance électrique stable est maîtrisée.

### EXPOSÉ DE L'INVENTION

Le but précédemment énoncé est atteint par un thermogénérateur comportant au moins un thermoélément et deux éléments à matériaux à changement de phase, présentant des températures de changement de phase différentes, les éléments à matériaux à changement de phase étant disposés de part et d'autre du thermoélément de sorte que celui-ci ne voie que le gradient de température imposé par les deux éléments à matériaux à changement de phase. Ainsi, lorsque chacun des éléments à matériau à changement de phase est composé à la fois d'une phase liquide et d'une phase solide, il est à une température constante. Par conséquent le gradient de température à travers le thermoélément est constant. Le thermoélément est alors apte à délivrer une puissance électrique stable.

En d'autres termes, les éléments à matériau à changement de phase et le thermoélément sont disposés thermiquement en série, i.e. le thermoélément est donc soumis uniquement aux températures des deux éléments à matériaux à changement de phase.

On cherche à délivrer une puissance thermique constante au thermoélément, ce qui sous-entend un gradient de température constant puisque tous les autres paramètres sont déjà constants.

Les éléments à matériau à changement de phase sont disposés sur les deux faces du thermoélément, de sorte qu'elles soient soumises entièrement aux températures du matériau à changement de phase.

De manière particulièrement avantageuse, on peut prévoir de réaliser des courts-circuits thermiques entre les deux matériaux à changement de phase afin d'allonger la période pendant laquelle le gradient de température à travers le thermoélément est constant, en phase de fusion. Ces courts-circuits thermiques peuvent être réalisés par une communication fluidique entre les éléments à matériaux à changement de phase, provoquant une apparition prématurée d'un germe de liquide dans le matériau à changement de phase non soumis directement à la source de chaleur. On réalise des connexions entre les réservoirs de matériaux à changement de phase pour créer rapidement l'apparition d'un germe dans le matériau le moins exposé et allongé la période durant laquelle la température est constante.

De manière également particulièrement avantageuse, on peut prévoir des zones dans lesquelles la solidification est retardée permettant d'allonger la période pendant laquelle le gradient de température est constant, en phase de solidification. Pour cela, on prévoit une zone dans laquelle l'épaisseur de matériau à changement de phase est supérieure à la distance du front de fusion.

La présente invention a alors pour objet un thermogénérateur comportant au moins un thermoélément et deux matériaux à changement de phase présentant des températures de changement de phase différentes, ledit au moins un thermoélément comportant deux faces principales opposées, chacune desdites faces étant recouverte par un des matériaux à changement de phase de sorte que le thermoélément ne voit que le gradient de température imposé par les deux matériaux à changement de phase, lors d'une phase d'échauffement ou de refroidissement.

Dans un exemple de réalisation, le thermogénérateur comporte des enceintes contenant les matériaux à changement de phase, chaque enceinte comportant une première et une deuxième pièce, la première pièce comportant une plaque plane dont une face est munie d'ailettes en saillie, et la deuxième pièce comportant une plaque plane dont une face est en contact avec le thermoélément et l'autre face est munie d'ailettes en saillie, les deux première et deuxième pièces étant montées face à face de sorte que les ailettes s'interpénètrent définissant un cavité dans laquelle est située le matériau à changement de phase.

De manière avantageuse, l'épaisseur de matériau à changement de phase dans au moins une partie de chacune des enceintes est de l'ordre et, de préférence, légèrement inférieure ou égale à la distance du front de fusion, la distance du front de fusion étant égale à $\sqrt{\dfrac{2.k.\Delta T.t}{L}}$ , k étant la conduction thermique du matériau à changement de phase, L étant la chaleur latente de fusion du matériau à changement de phase, $\Delta T$ étant la différence de température entre la température de la paroi de l'ailette et la température de changement de phase du matériau à changement de phase, et t étant le temps.

De manière particulièrement avantageuse, le thermogénérateur selon la présente invention comporte des moyens pour mettre directement en contact les deux matériaux à changement de phase.

Lesdits moyens pour mettre directement en contact les deux matériaux à changement de phase peuvent comporter au moins un conduit reliant une enceinte dans laquelle se trouve le premier matériau à changement de phase et une enceinte dans laquelle se trouve le deuxième matériau à changement de phase, ledit conduit étant rempli partiellement par le premier matériau à changement de phase et par le deuxième matériau à changement de phase.

De manière préférée, la dimension transversale du conduit est inférieure ou égale à la distance du front de fusion, la distance du front de fusion étant égale à $\sqrt{\dfrac{2.k.\Delta T.t}{L}}$ , k étant la conduction thermique du matériau à changement de phase, L étant la chaleur latente de fusion du matériau à changement de phase, $\Delta T$ étant la différence de température entre la température de paroi du conduit et la température de changement de phase du matériau à changement de phase, et t étant le temps.

Selon, un mode préféré de l'invention, la dimension transversale du conduit est très inférieure à la distance du front de fusion, par exemple, ne représentant que 0,01 à 50 % de cette distance, ou encore de 0,1 à 20 %.

Le conduit peut être en un matériau offrant une bonne conductivité thermique, c'est-à-dire un matériau dont la conductivité thermique est supérieure à celle des MCP utilisés dans l'invention.

Par exemples le conduit peut-être en aluminium, en acier en cuivre ou en inox.

Avantageusement, une portion centrale du conduit est faite en un matériau présentant une conductivité thermique limitée, c'est-à-dire dont la conductivité thermique est inférieure à celle des matériaux à changement de phase.

Par exemple, ladite portion du conduit peut être en verre ou en matériau plastique.

Il peut être prévu qu'au moins un volume de liquide sépare les premier et deuxième matériaux à changement de phase dans ledit conduit.

De manière également particulièrement avantageuse, l'enceinte contenant le matériau à changement de phase présentant la température de changement de phase la plus élevée comporte une zone de matériau à changement de phase dont l'épaisseur est supérieure à la distance du front de fusion.

Ceci peut être obtenu en prévoyant que la distance entre deux ailettes est localement supérieure à la distance du front de fusion. En variante, on prévoit que l'enceinte comportant un réservoir rapporté contenant du matériau à changement de phase, la dimension transversale dudit réservoir étant supérieure à la distance du front de fusion.

De préférence, le thermogénérateur selon l'invention est entouré de moyens d'isolation thermique pour guider le flux thermique à travers l'empilement formé par les matériaux à changement de phase et le au moiris un thermoélément.

La présente invention a également pour objet un système génération d'électricité comportant un thermogénérateur selon la présente invention et une source de chaleur.

La source de chaleur peut être disposée du côté de l'enceinte contenant le matériau à changement de phase présentant la température de changement de phase la plus élevée.

Dans un autre exemple de réalisation, le système de génération d'électricité selon l'intention peut comporter un circuit fluidique fermé, contenant un fluide caloporteur, ledit circuit étant apte à échanger de la chaleur avec le premier et le deuxième matériau à changement de phase, et traversant la source de chaleur, dans lequel la source de chaleur est située en aval du matériau à changement de phase ayant la température de changement de phase la plus basse et en amont du matériau à changement de phase ayant la température de changement de phase la plus haute dans le sens d'écoulement du fluide caloporteur, et dans lequel, lorsque le caloporteur échange avec le matériau à changement de phase ayant la température de changement de phase la plus basse, sa température est au moins égale à la température de changement de phase dudit matériau, et lorsque le caloporteur échange de la chaleur avec le matériau à changement de phase ayant la température de changement de phase la plus haute, sa température est au moins égale à la température de changement de phase dudit matériau.

La source de chaleur est par exemple formée par au moins un circuit intégré.

## BRÈVE DESCRIPTION DES DESSINS

La présente invention sera mieux comprise à l'aide de la description qui va suivre et des dessins en annexes, sur lesquels :

- la figure 1 est une représentation schématique d'un thermogénérateur selon la présente invention,
- la figure 2A est une représentation schématique d'un exemple de réalisation pratique d'un thermogénérateur selon la présente invention comportant des courts-circuits thermiques entre les deux matériaux à changement de phase,

- la figure 2B est une vue de détail de la figure 2A,
- les figures 3A à 3C sont des vues de détail de la figure 2A au niveau d'un court-circuit thermique dans différents états,
- les figures 4A à 4C sont des vues d'une variante de réalisation d'un court-circuit thermique dans différents états,
- la figure 5 est une représentation schématique d'un système de génération d'électricité comportant thermogénérateur selon la présente invention associé à un circuit fluidique,
- la figure 6 est une représentation graphique de l'évolution de l'énergie stockée ou, libérée dans les matériaux à changement de phase en fonction de la température.

## EXPOSÉ DÉTAILLÉ DE MODES DE RÉALISATION PARTICULIERS

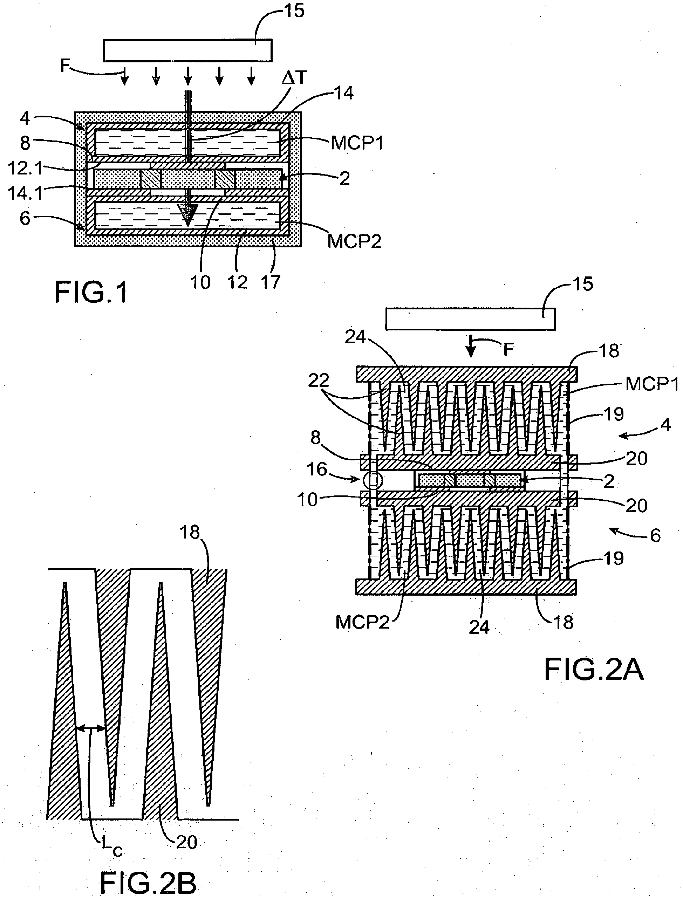

Sur la figure 1, on peut voir une représentation schématique d'un thermogénérateur selon la présente invention comportant un thermoélément 2 et des premier et deuxième éléments 4, 6 contenant chacun un matériau à changement de phase MCP1, MCP2. Dans la suite de la description, ont désignera les matériaux à changement de phase par "matériau MCP1" et "matériau MCP2".

Le thermoélément 2 est muni de deux faces opposées 8, 10 de plus grandes surfaces. Chacune des faces 8, 10 est en contact avec un des éléments à matériau à changement de phase 4, 6.

Les premier et deuxième éléments 4, 6 à matériau à changement de phase recouvrent entièrement les deux faces 8, 10 du thermoélément 2.

Les premier et deuxième éléments 4, 6 à matériau à changement de phase comportent chacun une enceinte 12, 14 munie d'une face 12.1, 14.1 en contact avec une face 8, 10 du thermoélément 2, et le matériau MCP1, MCP2 disposé dans l'enceinte 12, 14.

De manière avantageuse, le thermogénérateur est entouré par un isolant thermique 17 guidant le flux thermique le long de l'axe de l'empilement et réduisant également les pertes de chaleur vers l'extérieur.

Selon l'invention, les matériaux MCP1, MCP2 présentent des températures de changement de phase solide-liquide $T_{f1}$, $T_{f2}$ différentes.

Le matériau MCP1 présente la température de fusion la plus élevée et est destiné à être disposé du côté d'une source de chaleur 15. Cette source de chaleur peut être un circuit intégré d'un ordinateur, une cellule photovoltaïque, un composant solaire thermique, un composant électronique de puissance comme un transistor bipolaire à porte isolée ou transistor IGBT ("Insulated Gate Bipolar Transistor en anglais, un composant microélectronique comme un microprocesseur...

Le terme « thermoélément » désigne tout dispositif apte à générer une puissance électrique lorsqu'il est soumis à un gradient de température.

Par exemple, le thermoélément 2 comporte un substrat et une ou plusieurs jonctions P-N connectées en série. Les jonctions P-N sont formées par un matériau semi-conducteur dopé N et un matériau semi-conducteur dopé P. Les matériaux sont disposés de manière alternée et s'étendent entre les deux faces 8, 10 du thermoélément. Des interconnexions sont prévues entre les matériaux dopés N et les matériaux dopés P adjacents de sorte à former les jonctions P-N. Les deux matériaux d'une jonction P-N voient donc le même flux thermique imposé par les matériaux MCP1 et MCP2. Les jonctions P-N sont connectées électriquement en série.

Les matériaux des jonctions P-N sont séparés par le substrat, qui est choisi de sorte à être un isolant électrique pour éviter la mise en court-circuit électrique des jonctions P-N et de sorte à être un bon isolant thermique pour empêcher un court-circuit thermique entre le matériau MCP1 et le matériau MCP2. Le substrat peut être par exemple en polymère souple, en céramique ou en métal. Le polymère utilisé peut être un polymère thermodurcissable.

La tension ΔV aux bornes du module est fonction du nombre de jonctions P-N, plus celui-ci est grand plus la tension est élevée.

La connexion entre les matériaux dopés N et les matériaux dopés P et les interconnexions entre les jonctions P-N sont par exemple en cuivre.

Le matériau MCP1 a une température de changement de phase T1, il impose la température T1 à la face 8 du thermoélément et la face 10 du thermoélément est à température du matériau MCP2 $T_2$.

C'est la différence ΔT = T1 - T2 qui est responsable de l'apparition d'une tension ΔV aux bornes du module thermoélectrique 2.

L'effet Seebeck se traduit par la relation suivante :

$$\Delta V = \Delta T . S$$

avec

- ΔV la différence de potentiel en Volt aux bornes du module thermoélectrique,
- ΔT le gradient de température en °C au niveau des jonctions P-N,
- S le coefficient Seebeck en $V.K^{-1}$.

Ainsi, plus le gradient de température ΔT imposé est élevé, plus la différence de potentiel ΔV générée par le thermogénérateur est élevée.

La valeur de ΔT est choisie en fonction de la puissance souhaitée, par exemple si l'on souhaite une puissance de quelques centaines de milliwatts, une différence de température ΔT de 20°C suffit. Dans le cas d'une puissance recherchée de quelques watts, une différence de température de plusieurs centaines de °C est requise.

Lors d'un apport de chaleur par la source de chaleur, les matériaux à changement de phase passent progressivement d'un état solide à l'état liquide, le liquide étant confiné dans l'enceinte.

Le thermoélément 2 est alors soumis à un gradient de température entre sa première face 8 et sa deuxième face. Les éléments à matériau à changement de phase forment un tampon thermique entre la source de chaleur et le thermoélément d'une part et en face arrière du thermoélément d'autre part, et imposent ainsi un gradient thermique au thermoélément.

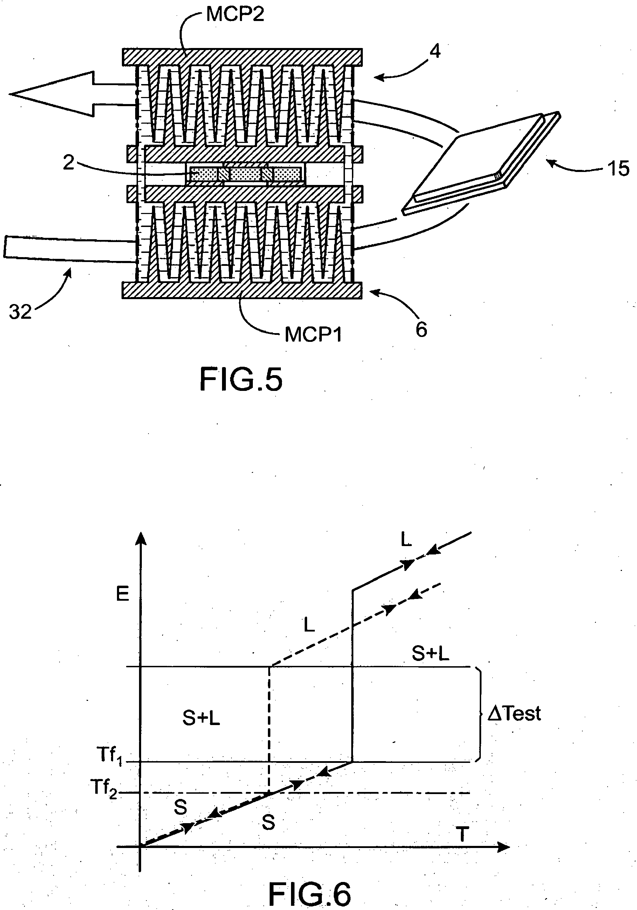

Sur la figure 6, on peut voir représentée la variation de l'énergie stockée et l'énergie libérée E en fonction de la température T pour les deux matériaux MCP1, MCP2. La variation d'énergie du matériau MCP1 est représentée en trait plein, et celle de MCP2 en tirets. La référence S désigne la phase solide seule, la référence L désigne la phase liquide seule, et la référence S + L la mélange de la phase liquide et de la phase solide.

Chacun des matériaux MCP1, MCP2 présentent des températures constantes $T_{f1}$, $T_{f2}$ tant que coexistent une phase solide et une phase liquide. Ces périodes sont représentées par les traits verticaux sur la figure 6.

La zone désignée ΔTcst durant laquelle les deux matériaux à changement phase sont simultanément à des températures constantes $T_{f1}$, $T_{f2}$ est délimitée par les traits pleins horizontaux. C'est cette période qui permet la génération d'une puissance électrique stable.

Selon la présente invention, le thermoélément ne voit que le gradient de température imposé par les deux matériaux à changement de phase MCP1, MCP2. Par conséquent, lors de la période où les deux matériaux MCP1, MCP2 sont à températures constantes $T_{f1}$, $T_{f2}$, le gradient de température vu par le thermoélément 2 est constant. Le thermogénérateur peut alors produire une puissance électrique stable.

Grâce à l'invention, il est alors aisé d'obtenir grâce à des matériaux à changement phase la génération d'une puissance stable à partir d'une source de chaleur.

Sur les figures 2A et 2B, on peut voir un mode de réalisation particulièrement avantageux d'un thermogénérateur selon la présente invention offrant de périodes allongées de génération d'une puissance électrique stable.

Les références utilisées pour la figure 1 seront reprises pour désigner les mêmes éléments sur la figure 2A.

Ce mode de réalisation diffère de celui de la figure 1, notamment en ce que le thermogénérateur comporte des moyens 16 formant des courts-circuits thermiques entre le premier élément à matériau à changement de phase 4 et le deuxième élément à matériau à changement de phase 6.

En outre, sur la figure 2A on peut voir un exemple de réalisation pratique des éléments à matériau à changement de phase 4, 6 et plus particulièrement des enceintes.

Dans cet exemple, chaque enceinte comporte une paroi extérieure 19, par exemple en verre, type Pyrex® et des moyens pour transférer la chaleur entre le matériau à changement de phase, et le thermoélément. La conductivité thermique de l'enceinte est faible et préférablement inférieure à celle du MCP.

Dans l'exemple représenté, les moyens pour transférer la chaleur comporte une pièce extérieure 18 et une pièce intérieure 20 emboîtées l'une dans l'autre. Les pièces 18, 20 comportent une plaque 18.1 et des ailettes 22 en saillie de l'une des faces de la plaque 18.1. Les pièces sont réalisées en un matériau offrant une bonne conductivité thermique, tel qu'en aluminium ou en cuivre.

Les ailettes 22 ont par exemple une section triangulaire. Les ailettes 22 ont pour fonction de développer une surface d'échange thermique supérieure entre le matériau à changement de phase et l'environnement extérieur. On caractérise les pièces par leur facteur de « développement de surface » qui st égal au rapport de la surface de pièce avec ailettes sur la surface de pièce sans ailette. Par exemple, un facteur de développement de 2 permet de doubler la densité de puissance de stockage du matériau à changement de phase. De préférence, on choisira des pièces présentant. Sur la figure 2A le facteur de développement des pièces est de l'ordre de 6.

Les deux pièces 18, 20 sont emboîtées l'une dans l'autre de sorte qu'une ailette 22 d'une pièce 18, 20 soit reçue entre deux ailettes 22 de l'autre pièce 20, 18. Ces deux pièces 18, 20 définissent alors une cavité 24 ayant une section en zigzag. La face plane de la plaque 18.1 de la pièce extérieure 18 du premier élément à matériau à changement de phase 4 reçoit le flux thermique F de la source de chaleur 15, et la face plane de la pièce intérieure 20 du premier élément à matériau à changement de phase 2 et la face plane de la pièce intérieure 20 sont en contact avec le thermoélément 2.

Les ailettes 22 des pièces intérieures 20 forment des ailettes conduisant la chaleur du matériau MCP1 vers le thermoélément 2, puis du thermoélément 2 vers le matériau MCP2.

Dans le cas de l'élément à matériau à changement de phase 4 situé du côté de la source de chaleur 15, les ailettes 22 de la pièce extérieure 18 servent également à conduire la chaleur de la source de chaleur 15 vers le matériau MCP1.

Les pièces intérieures 20 sont par exemple collées sur les faces du thermoélément 2 afin d'assurer une bonne conduction thermique.

L'assemblage entre la paroi extérieure et les deux pièces 18, 20 est rendu étanche aux matériaux à changement de phase par des moyens classiques connus de l'homme du métier.

Le matériau MCP1 est par exemple du RT58® dont la température de changement de phase est 58°C et le matériau MCP2 est du RT35H® dont la température de changement de phase est 35°C de la société Rubitherm®.

A des fins de simplicité de construction, les deux enceintes sont identiques, cependant, concernant l'enceinte contenant le matériau MCP2, celle-ci pourrait ne pas comporter d'ailettes 22 au niveau de là pièce extérieure 18, puisqu'on ne souhaite pas conduire la chaleur vers l'extérieure du thermogénérateur.

De manière avantageuse, l'épaisseur des matériaux à changement de phase est sensiblement constante dans chacune des enceintes. Cette épaisseur correspond à la distance séparant les faces en regard de deux ailettes 22 adjacentes, qui forme deux surfaces d'échange thermique avec le matériau à changement de phase.

L'épaisseur moyenne de matériau à changement de phase correspond à une longueur caractéristique Lc.

De manière particulièrement avantageuse, la longueur caractéristique Lc est de l'ordre de, et de préférence inférieure ou égale à la distance parcourue par le front de fusion. Par de l'ordre de, on entend qu'on tolère une différence de plus ou moins 30 %. Ainsi, la chaleur transmise par les ailettes 22 peut traverser toute l'épaisseur du matériau et le fondre entièrement dans une période de temps donné dépendant de la source de chaleur.

La distance du front de fusion est donnée par la relation suivante :

$$\text{Distance du front de fusion} = \sqrt{\frac{2.k.\Delta T.t}{L}}$$

avec :

k : la conduction thermique,

L : la chaleur latente de fusion du MCP,

$\Delta T$ : la différence de température entre la température de la paroi des ailettes et la températures de changement de phase du MCP,

t : le temps.

La puissance de stockage d'un matériaux à changement de phase est donnée par la relation suivant

$$\text{Puissance stockage} = \sqrt{\frac{L.k\Delta T}{2t}}$$

Par conséquent la distance du front de fusion dépend de la puissance de stockage et du temps.

Dans le tableau ci-dessous, sont regroupées différentes valeurs de distance du front de fusion en fonction de la puissance de stockage et du temps, en considérant que les matériaux MCP1 et MCP2 ont une conduction thermique égale à 0,2 W/m/K et la source de chaleur est à une température de 100°C.

| $L_c$ | Stockage | | | |
|---|---|---|---|---|
| | 400 W/m² | | 1000 W/m² | |
| | tps d'expérience | | | |
| | 0,2 hr | 1,0 hr | 0,1 hr | 0,2 hr |
| MCP1 ΔT100°C-58°C | 0,9 cm | 2,0 cm | 0,6 cm | 0,9 cm |
| MCP2 ΔT=58°C-35°C | 0,7 cm | 1,5 cm | 0,4 cm | 0,7 cm |

En fonction des conditions de fonctionnement du thermogénérateur, on peut calculer l'épaisseur maximale avantageuse des matériaux à changement de phase dans les enceintes.

Il est bien entendu qu'il n'est en aucun cas nécessaire que les deux matériaux aient la même conductivité thermique. On peut prévoir qu'elles soient différentes, dans ce cas les épaisseurs des deux matériaux à changement de phase dans les deux enceintes seraient différentes.

Nous allons décrire en détail les moyens 16 de court-circuit thermique.

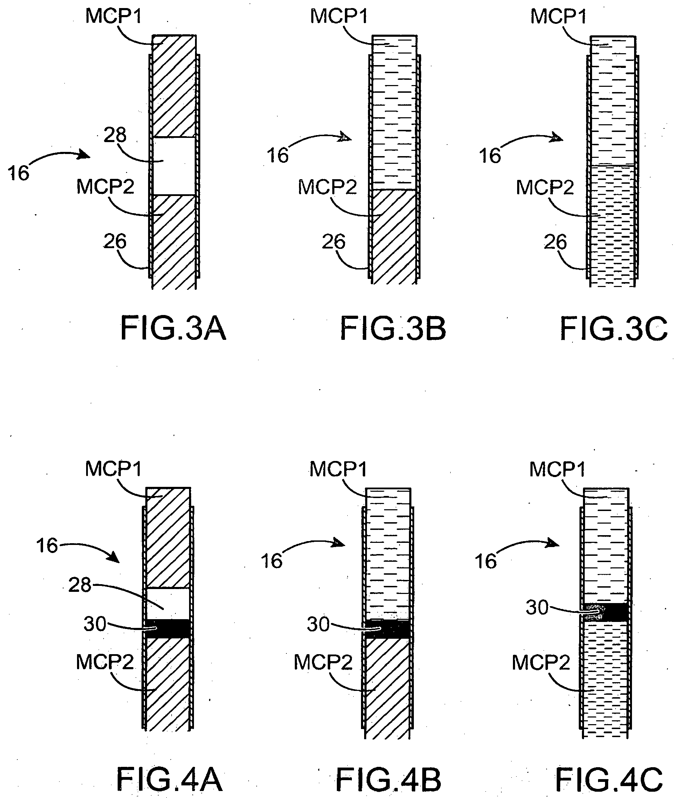

Sur les figures 3A à 3C, on peut voir un exemple de tels moyens 16 de court-circuit thermique dans trois états différents.

Dans cet exemple, les moyens 16 de court-circuit thermique comportent un ou plusieurs conduits 26 reliant l'intérieur du réservoir du matériau MCP1 au réservoir du matériau MCP2. Dans l'exemple représenté, le thermogénérateur comporte deux conduits 26. Lorsque les matériaux MCP1 et MCP2 sont à l'état solide, la partie du conduit du côté de l'enceinte contenant le matériau MCP1, partie supérieure dans la représentation de la figure 2A, est remplie de matériau MCP1, et la partie du conduit du côté de l'enceinte contenant le matériau MCP2, partie inférieure dans la représentation de la figure 2A, est remplie de matériau MCP2. Un volume 28 rempli de gaz, par exemple d'air, est prévu entre les deux matériaux MCP1, MCP2 à l'état solide.

De manière avantageuse, le conduit 26 est en matériau offrant une bonne conductivité thermique, il est par exemple en métal, par exemple en aluminium ou en cuivre.

De manière encore plus avantageuse, la portion centrale du conduit s'étendant entre au moins l'interface matériau MCP1-air ou liquide et au moins l'interface air ou liquide et matériau MPC2, présente une faible conductivité thermique de sorte que la majorité de la chaleur, par exemple de l'ordre d'au moins 90 % passe par les matériaux à changement de phase et non par la paroi du conduit. Par exemple, cette portion de conduit est réalisé en un matériau présentant une conductivité thermique inférieure à celle des matériaux à changement de phase, par exemple tel qu'un matériau plastique ou un verre et/ou présenter une épaisseur réduite afin d'offrir une section réduite pour le flux thermique. Par exemple cette portion centrale peut représenter entre 10 % et 30 % de la longueur totale du conduit.

Le thermogénérateur selon ce mode de réalisation peut aussi comporter plusieurs conduits 26 repartis entre les enceintes contenant les matériaux MCP1, MCP2.

Le thermogénérateur peut aussi comporter plusieurs conduits disposés l'un à côté de l'autre.

Lorsque le matériau MCP1 fond, il se dilate et entre en contact avec le matériau MCP2 auquel il transmet de la chaleur, provoquant sa fusion. Les matériaux MCP1 et MCP2 sont choisis non miscibles.

De manière particulièrement avantageuse, la dimension transversale du conduit 26, i.e. son diamètre dans le cas d'un conduit à section circulaire, est inférieure à la dimension caractéristique Lc, afin d'obtenir rapidement une fusion complète du matériau à changement de phase MCP1 dans le conduit, en particulier en son centre. La distance du front de fusion correspond à la distance parcourue par le front de fusion pendant un temps donné. En choisissant le diamètre du conduit inférieur à cette distance, le front de fusion aura parcouru le diamètre du tube, on est alors sûr que tout le matériau MCP1 dans le conduite est fondu.

Les exemples de dimensions donnés précédemment s'appliquent également pour le dimensionnement des conduits. Ainsi, en fonction des conditions de fonctionnement du thermogénérateur, on peut calculer le diamètre maximal avantageux pour le conduit reliant les deux enceintes.

Le rapport entre le volume de matériau MCP2 contenu dans le conduit et le volume au volume de matériau MCP2 dans l'enceinte est avantageusement inférieur à 30 %, de préférence inférieur à 20 %, de préférence encore de l'ordre de 2 à 15 %.

Nous allons maintenant expliquer le fonctionnement de ce thermogénérateur, en considérant que les matériaux MCP1, MCP2 sont solides.

Lorsque l'élément à matériau de changement de phase MCP1 est soumis à une source de chaleur, le matériau à changement de phase MCP1 commence à fondre, le matériau MCP1 situé dans le conduit 26 se met également à fondre (figure 3A). Lors de la fusion le matériau MCP1 est à la température constante $T_{f1}$. Il entre alors en contact avec le matériau MCP2 situé dans le conduit (figure 3B). Il y a alors transmission d'une faible quantité de chaleur entre le matériau MCP1 et le matériau MCP2 dans le conduit, ce dernier se met à fondre (figure 3C). Le matériau MCP2 est alors à la température constante $T_{f2}$.

Ainsi, grâce à ces moyens 16 de court-circuit thermique, on provoque plus rapidement l'apparition du premier germe de liquide du matériau MCP2 quelle que soit la résistance thermique formée par le thermoélément, sans pourtant accélérer la fusion complète de tout le matériau MCP2. Dés l'apparition du premier germe de liquide du matériau MCP2, le matériau MCP2 est à la température $T_{f2}$ jusqu'à la disparition du dernier germe de matériau MCP2 solide. Par conséquent, la période durant laquelle les deux matériaux MCP1, MCP2 sont à températures constantes est allongée.

On évite alors que tout le matériau MCP1 ou une grande partie de celui-ci soit fondu avant que le matériau MCP2 fonde. Ceci est obtenu en court-circuitant la résistance thermique formée par le thermoélément.

Ces moyens de court-circuit thermique permettent de créer rapidement un germe de liquide du matériau MCP2 sans pour autant réduire le volume de matériau MCP2 participant à la création du gradient thermique, puisque les matériaux utilisés dans le conduit sont ajoutés et ne participent pas dans tous les cas à la création du gradient thermique. Cette quantité de matériau n'est pas "vue" par le thermoélément.

Il est bien entendu que les différents conduits pourraient avoir des diamètres différents les uns des autres, ainsi la fusion complète dans les conduits ayant les plus grands diamètres serait plus tardive que dans les conduits ayant les plus petits diamètres. On peut également envisager un ou des conduits avec un diamètre variable. Cette variante permet d'avoir un système à réponse modulable : à section de conduit croissante, il sera ainsi possible de court-circuiter des puissances ou temps de source supérieurs (voir les données dans le tableau ci-dessus) pour un même dispositif.

Sur les figures 4A à 4C, on peut voir une variante des moyens de court-circuit entre les deux enceintes. Dans cette variante, le volume 28 entré les deux matériaux est rempli partiellement d'un liquide 30, par exemple de l'eau. Ce liquide n'est miscible ni avec le matériau MCP1, ni avec le matériau MCP2. Le volume de liquide 30, du fait de sa déformabilité, assure une bonne interface entre le matériau MCP1 fondu et le matériau MCP2 non encore fondu.

Le fonctionnement de ces moyens de court-circuit est similaire à celui de moyens représentés sur les figures 3A à 3C et ne sera pas répété ici.

De manière avantageuse, le thermogénérateur selon la présente invention comporte également des moyens pour retarder la solidification totale du matériau MCP1, qui est le matériau ayant la température de fusion $Tf_1$ la plus élevée.

Les moyens pour retarder la solidification complète du matériau MCP1 sont formés par une zone contenant du matériau MCP1 dont les dimensions, en particulier la dimension entre deux surfaces intérieures de l'enceinte est augmentée par rapport au reste de l'enceinte.

Par exemple, dans le cas du thermogénérateur de la figure 2A, on peut prévoir que la cavité en zigzag comporte une zone dans laquelle la distance entre deux ailettes des deux pièces 18, 20 définissant un canal soit supérieure à la dimension caractéristique Lc, par exemple doublée ou plus. On peut prévoir en variante que l'enceinte comporte un réservoir additionnel rapporté, dont la dimension transversale est plus grande que la dimension caractéristique.

Le rapport entre le volume de la portion de matériau MCP1 ayant une épaisseur supérieure à la distance du front de fusion et le volume de matériau MCP1 totale est avantageusement inférieur à 30 %, de préférence inférieur à 20 %, de préférence encore de l'ordre de 2 à 15 %.

Nous allons maintenant expliquer le fonctionnement de ce thermogénérateur, en considérant que les matériaux MCP1, MCP2 sont à l'origine liquides.

En l'absence d'une source de chaleur, les enceintes se refroidissent, et de fait les ailettes 22 aussi, ce qui provoque une baisse de température des matériaux MCP1 et MCP2.

Le matériau MCP1 étant celui qui à la température de fusion la plus élevée, il se solidifie le premier.

Tant que la solidification du matériau MCP1 a lieu et qu'il existe de la phase liquide, la température du matériau MCP1 est à la température $T_{f1}$. Le gradient de température à travers le thermoélément est donc constant. En prévoyant cette zone de dimension augmentée, la solidification du matériau MCP1 dans cette zone est retardée par rapport au reste du matériau MCP1. On prolonge dont l'existence d'une phase liquide du matériau MCP1 et donc le maintien d'une température constante $T_{f1}$, et donc le maintien d'un gradient de température constant.

Sur la figure 5, on peut voir schématisé un autre mode de fonctionnement d'un themogénératèur selon la présente invention associé à un circuit fluidique.

Au contraire des thermogénérateurs des figures 1 et 2A, la source de chaleur n'irradie pas directement le premier élément à matériau à changement de phase, mais échange de la chaleur avec un circuit fluidique 32 dans lequel circule un fluide caloporteur.

La source de chaleur est située en aval le deuxième élément à matériau à changement de phase 6 et en amont de l'élément à matériau à changement de phase 4 dans le sens d'écoulement du fluide caloporteur. Le circuit fluidique 32 forme une boucle fermée et traverse le deuxième élément à matériau à changement de phase 6, la source chaude 15 et le premier élément à matériau à changement de phase 4. Le fluide caloporteur a une température au moins égale à la température de changement de phase du matériau MCP2.

Les enceintes des éléments à changement de phase sont telles qu'elles délimitent des cavités pour les matériaux à changement de phase MCP1 et MCP2 et des canaux pour la circulation étanche du caloporteur. On peut prévoir par exemple des tubes traversant de manière étanche les enceintes des éléments à matériau à changement de phase 4, 6.

La source chaude est par exemple un circuit intégré dans un ordinateur.

Nous allons maintenant expliquer le fonctionnement du circuit de la figure 5.

Le caloporteur "froid" traverse le deuxième élément à matériau à changement de phase et provoque la fusion partielle du matériau MCP2. Puis, il traverse la source chaude dans laquelle le caloporteur est échauffé jusqu'à une température eau moins égale à $T_{f1}$. Le caloporteur échauffé traverse ensuite le premier élément à matériau à changement de phase provoquant la fusion partielle du matériau MCP1. Le caloporteur est ensuite refroidi puis renvoyé dans le deuxième élément à matériau à changement de phase.

Tant que le caloporteur circule dans le circuit, les matériaux MCP1 et MCP2 sont en cours de transition de phase solide-liquide. La température de chacune des éléments à matériau à changement de phase est constante, et de fait le gradient de température appliqué au thermoélément. Le thermogénérateur génère alors une puissance électrique stable.

Le système de la figure 5 est particulièrement adapté au refroidissement de circuits intégrés d'un ordinateur, la chaleur ainsi extraite permettant la génération d'électricité qui peut être utilisée par l'ordinateur. Tant que l'ordinateur fonctionne, le caloporteur circule dans le circuit 32 et maintient les matériaux MCP1, MCP2 dans un état transitoire de changement de phase.

Du fait du comportement réversible des matériaux à changement de phase, comme cela est visible sur la figure 6, il est possible, grâce à l'invention d'obtenir une génération d'énergie électrique stable de manière cyclique en fonction du fonctionnement cyclique de la source de chaleur : alternance de périodes d'émissions de chaleur (échauffement et fusion des matériaux MCP1 et MCP2) et de périodes de non émission e de chaleur (refroidissement et solidification des matériaux MCP1 et MCP2).

Il est bien entendu que le thermogénérateur selon l'invention peut comporter plusieurs thermoéléments connectés électriquement en série ou en parallèle en fonction de l'application. Les thermoéléments sont connectés thermiquement en parallèle. Les thermoéléments sont disposés les uns à côtés des autres entre les deux éléments à matériau à changement de phase.

Les matériaux à changement de phase pouvant être mis en oeuvre dans la présente invention peuvent être des matériaux organiques tel que le RT100® de Rubitherm® dont la température de changement des phase est 99°C, l'acide benzoïque dont la température de changement des phase est 122°C, le benzamide dont la température de changement des phase est 130°C, le stilbène dont la température de changement des phase est 123°C, l'erythritol dont la température de changement des phase est 118°C,...), des hydrates de sels tes que le $MgCl_2.6H_2O$ dont la température de changement des phase est 117°C, les sels tels que $KNO_3$-$NaNO_2$-$NaNO_3$ dont la température de changement des phase est 140°C, le $NaNO_3$-$KNO_3$ dont la température de changement des phase est 222°C..., ou des métaux tels que le Sn dont la température de changement des phase est 232°C....

De préférence, on choisira des couples de matériaux à changement de phase MCP1 et MCP2 présentant une différence importante de température, ce qui sera avantageux pour la puissance électrique générée.

**Revendications**

**1.** Thermogénérateur comportant au moins un thermoélément (2) et deux matériaux à changement de phase (MCP1, MCP2) présentant des températures de changement de phase ($T_{f1}$, $T_{f2}$) différentes, ledit au moins un thermoélément (2) comportant deux faces principales opposées (8, 10), chacune desdites faces (8, 10) étant recouverte par un des matériaux à changement de phase (MCP1, MCP2) de sorte que le thermoélément (2) ne voit que le gradient de température imposé par les deux matériaux à changement de phase (MCP1, MCP2), lors d'une phase d'échauffement ou de refroidissement.

**2.** Thermogénérateur selon la revendication 1, comportant des enceintes contenant les matériaux à changement de phase (MCP1, MCP2), chaque enceinte comportant une première et une deuxième pièce (18, 20), la première pièce (18) comportant une plaque plane (18.1) dont une face est munie d'ailettes (22) en saillie, et la deuxième pièce (20) comportant une plaque plane (20.1) dont une face est en contact avec le thermoélément (2) et l'autre face est munie d'ailettes (22) en saillie, les deux première (18) et deuxième (20) pièces étant montées face à face de sorte que les ailettes (22) s'interpénètrent définissant un cavité (24) dans laquelle est située le matériau à changement de phase (MCP1, MCP2).

3. Thermogénérateur selon la revendication 2, dans lequel l'épaisseur de matériau à changement de phase dans au moins une partie de chacune des enceintes est de l'ordre de la distance du front de fusion, la distance du front de fusion étant égale à $\sqrt{\dfrac{2.k.\Delta T.t}{L}}$ , k étant la conduction thermique du matériau à changement de phase, L étant la chaleur latente de fusion du matériau à changement de phase, $\Delta T$ étant la différence de température entre la température de la paroi de l'ailette et la température de changement de phase du matériau à changement de phase, et t étant le temps.

4. Thermogénérateur selon l'une des revendications 1 à 3, comportant des moyens (16) pour mettre directement en contact les deux matériaux à changement de phase (MCP1, MCP2).

5. Thermogénérateur selon la revendication 4, dans lequel les moyens (16) pour mettre directement en contact les deux matériaux à changement de phase comportent au moins un conduit (26) reliant une enceinte dans laquelle se trouve le premier matériau à changement de phase (MCP1) et une enceinte dans laquelle se trouve le deuxième matériau à changement de phase (MCP2), ledit conduit (26) étant rempli partiellement par le premier matériau à changement de phase et par le deuxième matériau à changement de phase.

6. Thermogénérateur selon la revendication 5, dans lequel la dimension transversale du conduit (26) est inférieure ou égale à la distance du front de fusion, la distance du front de fusion étant égale à $\sqrt{\dfrac{2.k.\Delta T.t}{L}}$ , k étant la conduction thermique du matériau à changement de phase, L étant la chaleur latente de fusion du matériau à changement de phase, $\Delta T$ étant la différence de température entre la température de la paroi du conduit et la température de changement de phase du matériau à changement de phase, et t étant le temps.

7. Thermogénérateur selon la revendication 5 ou 6, dans lequel au moins un volume de liquide (30) sépare les premier et deuxième matériaux à changement de phase dans ledit conduit.

8. Thermogénérateur selon l'une des revendications précédentes, comportant des enceintes contenant les matériaux à changement de phase (MCP1, MCP2), l'enceinte contenant le matériau à changement de phase (MCP1) présentant la température de changement de phase la plus élevée ($T_{f1}$) comportant une zone de matériau à changement de phase dont l'épaisseur est supérieure à la distance du front de fusion.

9. Thermogénérateur selon la revendication précédente en combinaison avec la revendication 2, dans laquelle la distance entre deux ailettes (22) est localement supérieure à la distance du front de fusion.

10. Thermogénérateur selon la revendication 8, ladite enceinte comportant un réservoir rapporté contenant du matériau à changement de phase (MCP1), la dimension transversale dudit réservoir étant supérieure à la distance du front de fusion.

11. Thermogénérateur selon l'une des revendications précédentes, étant entouré de moyens d'isolation thermique (17) pour guider le flux thermique à travers l'empilement formé par les matériaux à changement de phase (MCP1, MCP2) et le au moins un thermoélément (2).

12. Système de génération d'électricité comportant un thermogénérateur selon l'une des revendications précédentes et une source de chaleur (15).

13. Système génération d'électricité selon la revendication précédente, dans lequel la source de chaleur (15) est disposée du côté de l'enceinte contenant le matériau à changement de phase (MCP1) présentant la température de changement de phase la plus élevée ($T_{f1}$).

14. Système génération d'électricité selon la revendication 12, comportant un circuit fluidique (32) fermé, contenant un fluide caloporteur, ledit circuit étant apte à échanger de la chaleur avec le premier et le deuxième matériau à changement de phase (MCP1, MCP2), et traversant la source de chaleur (15), dans lequel la source de chaleur (15) est située en aval du matériau à changement de phase (MCP2) ayant la température de changement de phase la plus basse ($T_{f2}$) et en amont du matériau à changement de phase (MCP1) ayant la température de changement de phase la plus haute ($T_{f1}$) dans le sens d'écoulement du fluide caloporteur, et dans lequel, lorsque le caloporteur échange avec le matériau à changement de phase (MCP2) ayant la température de changement de phase la plus basse ($T_{f2}$), sa température est au moins égale à la température de changement de phase ($T_{f2}$) dudit matériau (MCP2), et lorsque le caloporteur échange de la chaleur avec le matériau à changement de phase (MCP1) ayant la température de changement de phase la plus haute ($T_{f1}$), sa température est au moins égale à la température de changement de phase ($T_{f1}$) dudit matériau (MCP1).

15. Système génération d'électricité selon la revendication 12, 13 ou 14, dans lequel la source de chaleur (15) est formée par au moins un circuit intégré.

**Patentansprüche**

1. Thermogenerator, umfassend wenigstens ein Thermoelement (2) sowie zwei Phasenänderungsmaterialien (MCP1, MCP2), die unterschiedliche Phasenänderungstemperaturen ($T_{f1}$, $T_{f2}$) aufweisen, wobei das wenigstens eine Thermoelement (2) zwei entgegengesetzte Hauptflächen (8, 10) umfasst, wobei jede der Flächen (8, 10) durch eines der Phasenänderungsmaterialen (MCP1, MCP2) derart bedeckt ist und wobei das Thermoelement (2) während einer Aufwärm- oder Abkühlphase nur den Temperaturgradienten sieht, der durch die zwei Phasenänderungsmaterialien (MCP1, MCP2) auferlegt wird.

2. Thermogenerator nach Anspruch 1, umfassend Umhüllungen, die die Phasenänderungsmaterialien (MCP1, MCP2) enthalten, wobei jede Umhüllung ein erstes und ein zweites Teil (18, 20) umfasst, wobei das erste Teil (18) eine ebene Platte (18.1) umfasst, deren eine Seite mit vorstehenden Flügeln (22) ausgestattet ist, und das andere Teil (20) eine ebene Platte (20.1) umfasst, deren eine Seite in Kontakt mit dem Thermoelement (2) ist und deren andere Seite mit vorstehenden Flügeln (22) ausgestattet ist, wobei die beiden ersten (18) und zweiten (20) Teile einander gegenüber derart montiert sind, dass sich die Flügel (22) gegenseitig durchdringen und einen Hohlraum (24) definieren, in welchem das Phasenänderungsmaterial (MCP1, MCP2) angeordnet ist.

3. Thermogenerator nach Anspruch 2, bei dem die Dicke des Phasenänderungsmaterials in wenigstens einem Teil von jeder der Umhüllungen in der Größenordnung des Abstands von der Schmelzfront ist, wobei der Abstand von der Schmelzfront gleich $\sqrt{\dfrac{2.k.\Delta T.t}{L}}$ ist, wobei k die Wärmeleitung des Phasenänderungsmaterials ist, L die latente Schmelzwärme des Phasenänderungsmaterials ist, $\Delta T$ die Temperaturdifferenz zwischen der Temperatur der Wand des Flügels und der Phasenänderungstemperatur des Phasenänderungsmaterials ist, und t die Zeit ist.

4. Thermogenerator nach einem der Ansprüche 1 bis 3, umfassend Mittel (16) zum direkten Inkontaktbringen der zwei Phasenänderungsmateriaüen (MCP1, MCP2).

5. Thermogenerator nach Anspruch 4, bei dem die Mittel (16) zum direkten Inkontaktbringen der zwei Phasenänderungsmaterialien wenigstens eine Leitung (26) umfassen, die eine Umhüllung, in welcher sich das erste Phasenänderungsmaterial (MCP1) befindet, und eine Umhüllung verbindet, in der sich das zweite Phasenänderungsmaterial (MCP2) befindet, wobei die Leitung (26) teilweise mit dem ersten Phasenänderungsmaterial und mit dem zweiten Phasenänderungsmaterial gefüllt ist.

6. Thermogenerator nach Anspruch 5, bei dem die transversale Abmessung der Leitung (26) kleiner oder gleich dem Abstand von der Schmelzfront ist, wobei der Abstand von der Schmelzfront gleich $\sqrt{\dfrac{2.k.\Delta T.t}{L}}$ ist, wobei k die Wärmeleitung des Phasenänderungsmaterials ist, L die latente Schmelzwärme des Phasenänderungsmaterials ist, $\Delta T$ die Temperaturdifferenz zwischen der Temperatur der Wand der Leitung und der Phasenänderungstemperatur des Phasenänderungsmaterials ist, und t die Zeit ist.

7. Thermogenerator nach Anspruch 5 oder 6, bei dem wenigstens ein Flüssigkeitsvolumen (30) das erste und das zweite Phasenänderungsmaterial in der Leitung trennt.

8. Thermogenerator nach einem der vorhergehenden Ansprüche, umfassend Umhüllungen, die die Phasenänderungsmaterialien (MCP1, MCP2) enthalten, wobei die Umhüllung, die dasjenige Phasenänderungsmaterial (MCP1) enthält, welches die höchste Phasenänderungstemperatur ($T_{f1}$) aufweist, eine Zone von Phasenänderungsmaterial umfasst, deren Dicke größer als der Abstand von der Schmelzfront ist.

9. Thermogenerator nach dem vorhergehenden Anspruch in Kombination mit Anspruch 2, bei dem der Abstand zwischen zwei Flügeln (22) lokal größer als der Abstand von der Schmelzfront ist.

10. Thermogenerator nach Anspruch 8, wobei die Umhüllung ein angebrachtes Reservoir umfasst, das Phasenänderungsmaterial (MCP1) enthält, wobei die transversale Abmessung des Reservoirs größer als der Abstand von der Schmelzfront ist.

11. Thermogenerator nach einem der vorhergehenden Ansprüche, der umgeben ist von Wärmeisolationsmitteln (17), um den Wärmefluss durch den Stapel zu führen, der durch die Phasenänderungsmateriaüen (MCP1, MCP2) und das wenigstens eine Thermoelement (2) gebildet wird.

12. Stromerzeugungssystem, umfassend einen Thermogenerator nach einem der vorhergehenden Ansprüche und eine Wärmequelle (15).

13. Stromerzeugungssystem nach dem vorhergehenden Anspruch, bei dem die Wärmequelle (15) an der Seite der Umhüllung angeordnet ist, die das Phasenänderungsmaterial (MCP1) enthält, welches die höchste Phasenänderungstemperatur ($T_{f1}$) aufweist.

14. Stromerzeugungssystem nach Anspruch 12, umfassend einen geschlossenen Fluidkreis (32), der ein Wärmeträgerfluid enthält, wobei der Kreis dazu ausgelegt ist, Wärme mit dem ersten und dem zweiten Phasenänderungsmaterial (MCP1, MCP2) auszutauschen, und die Wärmequelle (15) durchsetzt, wobei die Wärmequelle (15) stromabwärts des Phasenänderungsmaterials (MCP2) angeordnet ist, das die tiefste Phasenänderungstemperatur ($T_{f2}$) aufweist, und stromaufwärts des Phasenänderungsmaterials (MCP1), das die höchste Phasenänderungstemperatur ($T_{f1}$) aufweist, und zwar in der Strömungsrichtung des Wärmeträgerfluids, und wobei dann, wenn der Wärmeträger mit dem Phasenänderungsmaterial (MCP2) in Austausch tritt, das die niedrigste Phasenänderungstemperatur ($T_{f2}$) aufweist, seine Temperatur wenigstens gleich der Phasenänderungstemperatur ($T_{f2}$) des Materials (MCP2) ist, und wenn der Wärmeträger Wärme mit dem Phasenänderungsmaterial (MCP1) austauscht, das die höchste Phasenänderungstemperatur ($T_{f1}$) aufweist, seine Temperatur wenigstens gleich der Phasenänderungstemperatur ($T_{f1}$) des Materials (MCP1) ist.

15. Stromerzeugungssystem nach Anspruch 12, 13 oder 14, bei dem die Wärmequelle (15) durch wenigstens eine integrierte Schaltung gebildet ist.

**Claims**

1. A thermogenerator comprising at least one thermoelement (2) and two phase-change materials (MCP1, MCP2) having different phase-change temperatures ($T_{f1}$, $T_{f2}$), said at least one thermoelement (2) having two opposite main faces (8, 10), and each of said faces (8, 10) being covered by one of the phase-change materials (MCP1, MCP2), such that the thermoelement (2) is subject only to the temperature gradient imposed by the two phase-change materials (MCP1, MCP2), during a phase of heating or cooling.

2. A thermogenerator according to claim 1, comprising enclosures containing the phase-change materials (MCP1, MCP2), each enclosure having a first and a second part (18, 20), the first part (18) comprising a flat plate (18.1), one face of which is fitted with protruding fins (22), and the second part (20) comprising a flat plane (20.1), one face of which is in contact with the thermoelement (2), and the other face of which is fitted with protruding fins (22), the first (18) and second (20) parts being installed facing one another, such that the fins (22) interpenetrate, defining a cavity (24) in which the phase-change material (MCP1, MCP2) is present.

3. A thermogenerator according to claim 2, in which the thickness of the phase-change material in at least a proportion of each of the enclosures is of the order of the melt front distance, the melt front distance being equal to $\sqrt{\dfrac{2.k.\Delta T.t}{L}}$ , where k is the thermal conduction of the phase-change material, L is the latent heat of fusion of the phase-change material, $\Delta T$ is the temperature difference between the temperature of the wall of the fin and the phase-change temperature of the phase-change material, and t is the time.

4.  A thermogenerator according to one of the claims 1 to 3, comprising means (16) to bring the two phase-change materials (MCP1, MCP2) into direct contact.

5.  A thermogenerator according to claim 4, in which the means (16) to put the two phase-change materials into direct contact comprise at least one duct (26) connecting an enclosure in which the first phase-change material (MCP1) is present and an enclosure in which the second phase-change material (MCP2) is present, said duct (26) being partially filled by the first phase-change material and by the second phase-change material.

6.  A thermogenerator according to claim 5, in which the transverse dimension of the duct (26) is less than or equal to the melt front distance, where the melt front distance is equal to $\sqrt{\dfrac{2.k.\Delta T.t}{L}}$ , where k is the thermal conduction of the phase-change material, L is the latent heat of fusion of the phase-change material, $\Delta T$ is the temperature difference between the temperature of the wall of the duct and the phase-change temperature of the phase-change material, and t is the time.

7.  A thermogenerator according to claim 5 or 6, in which at least one volume of liquid (30) separates the first and second phase-change materials in said duct.

8.  A thermogenerator according to one of the previous claims, comprising enclosures containing the phase-change materials (MCP1, MCP2), the enclosure containing the phase-change material (MCP1) having the higher phase-change temperature ($T_{f1}$) comprising an area of phase-change material the thickness of which is greater than the melt front distance.

9.  A thermogenerator according to the previous claim in combination with claim 2, in which the distance between two fins (22) is locally greater than the melt front distance.

10. A thermogenerator according to claim 8, in which said enclosure comprises an added tank containing phase-change material (MCP1), the transverse dimension of said tank being greater than the melt front distance.

11. A thermogenerator according to one of the previous claims, surrounded by thermal insulation means (17) to guide the heat flux through the stack formed by the phase-change materials (MCP1, MCP2) and the at least one thermoelement (2).

12. An electricity generating system comprising a thermogenerator according to one of the previous claims and a heat source (15).

13. An electricity generating system according to the previous claim, in which the heat source (15) is positioned on the side of the enclosure containing the phase-change material (MCP1) having the higher phase-change temperature ($T_{f1}$).

14. An electricity generating system according to claim 12, comprising a closed fluid circuit (32), containing a heat-transfer fluid, said circuit being able to exchange heat with the first and second phase-change materials (MCP1, MCP2), and traversing the heat source (15), in which the heat source (15) is located downstream from the phase-change material (MCP2) having the lower phase-change temperature ($T_{f2}$), and upstream from the phase-change material (MCP1) having the higher phase-change temperature ($T_{f1}$) in the direction of flow of the heat transfer fluid, and in which, when the heat transfer fluid exchanges with the phase-change material (MCP2) having the lower phase-change temperature ($T_{f2}$), its temperature is at least equal to the phase-change temperature ($T_{f2}$) of said material (MCP2), and when the heat transfer fluid exchanges heat with the phase-change material (MCP1) having the higher phase-change temperature ($T_{f1}$), its temperature is at least equal to the phase-change temperature ($T_{f1}$)

of said material (MCP1).

15. An electricity generating system according to claim 12, 13 or 14, in which the heat source (15) is formed by at least one integrated circuit.

FIG.1

FIG.2A

FIG.2B

FIG.3A          FIG.3B          FIG.3C

FIG.4A          FIG.4B          FIG.4C

MCP2

4

2

15

32

MCP1

6

## FIG.5

E

L

L

S+L

S+L

ΔTest

$Tf_1$

$Tf_2$

S

S

T

## FIG.6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1001470 A
- US 2003143958 A